# EUROPEAN PATENT APPLICATION

(11) **EP 4 749 688 A1**
(43) Date of publication of application: **27.05.2026**
(21) Application number: 23949834.8
(22) Date of filing: 24.08.2023
(51) Int. Cl.: H01L 25/075, H10H 20/857, H10H 20/85, H01L 23/00

(54) **ASSEMBLY SUBSTRATE STRUCTURE FOR DISPLAY PIXELS, SEMICONDUCTOR LIGHT-EMITTING DEVICE PACKAGE FOR DISPLAY PIXELS, AND DISPLAY DEVICE COMPRISING SAME**

(71) Applicant: LG Electronics Inc., Yeongdeungpo-gu Seoul 07336 (KR)
(72) Inventor: KIM, Myoungsoo, Seoul 06772 (KR); PARK, Sungjin, Seoul 06772 (KR); PARK, Changseo, Seoul 06772 (KR); KIM, Gunho, Seoul 06772 (KR); KIM, Jungsub, Seoul 06772 (KR)
(74) Representative: Vossius & Partner Patentanwälte Rechtsanwälte mbB
(86) International application number: PCT/KR2023/012602
(87) International publication number: WO 2025/041894

(57) **Abstract**

Embodiments relate to an assembly substrate structure for a display pixel, a semiconductor light-emitting device package for a display pixel, and a display apparatus including the same.

An assembly substrate structure for a display pixel according to an embodiment may include a circular first assembly hole disposed in a first region of a predetermined assembly substrate, a second assembly hole disposed in a second region of the assembly substrate, and an elliptical third assembly hole disposed in a third region of the assembly substrate.

The first assembly hole, the second assembly hole, and the third assembly hole may each include a width in a first direction and a width in a second direction perpendicular to the first direction.

An increment of the width in the first direction of the second assembly hole and the third assembly hole may increase at a predetermined exclusive interval based on the width in the first direction of the first assembly hole.

## Description

### [Technical Field]

The present invention relates to a display pixel assembly board structure, a display pixel semiconductor light-emitting device package, and a display device including the same.

### [Background Art]

Large-area displays include liquid crystal displays (LCDs), organic light-emitting diode (OLED) displays, and micro-LED displays.

A micro-LED display uses micro-LEDs, semiconductor light-emitting devices with a diameter or cross-sectional area of 100 µm or less, as display elements.

Because micro-LED displays use micro-LEDs, semiconductor light-emitting devices, as display elements, they exhibit superior performance in many characteristics, including contrast ratio, response speed, color reproducibility, viewing angle, brightness, resolution, lifespan, luminous efficiency, and luminance.

In particular, micro-LED displays offer the advantages of being able to freely adjust the size and resolution of displays by separating and combining screens in a modular manner, and enabling the implementation of flexible displays.

However, large-scale micro-LED displays require millions of micro-LEDs, posing technical challenges in quickly and accurately transferring micro-LEDs onto the display panel.

Recently developed transfer technologies include the pick-and-place process, the laser lift-off method, and the self-assembly method.

Among these, the self-assembly method, in which semiconductor light-emitting elements autonomously find their assembly positions within a fluid, is advantageous for implementing large-screen display devices.

Recently, U.S. Patent No. 9,825,202 and others have presented micro-LED structures suitable for self-assembly. However, research on technologies for manufacturing displays through micro-LED self-assembly remains limited.

In particular, conventional technology can improve transfer speed when rapidly transferring millions of semiconductor light-emitting devices onto large displays. However, this can lead to a high transfer error rate, which in turn lowers the transfer yield.

A self-assembly transfer process using dielectrophoresis (DEP) has been attempted, but the non-uniformity of the DEP force has led to a low self-assembly yield.

Meanwhile, according to undisclosed internal technology, simultaneous assembly of red (R) micro-LED chips, green (G) micro-LED chips, and blue (B) LED chips using dielectrophoresis is being studied.

Research has been conducted on the exclusivity of chip shapes, where the horizontal cross-sections of the R, G, and B LED chips are different to ensure precise assembly into their respective assembly holes.

For example, according to undisclosed internal technology, the horizontal cross-section of the R LED chip was circular. Based on this, the major axis was increased and the minor axis was decreased at regular intervals to form two oval shapes, producing the B LED and G LED. Assembly hole patterns (one circular and two oval) corresponding to these circular and oval LEDs were formed on the substrate.

Furthermore, to enable LED assembly within the assembly holes, spaced assembly electrodes were formed within the assembly holes, and each assembly electrode was positioned so that it overlapped the LED chip. An electric field was then generated between the two opposing assembly electrodes to assemble the micro-LEDs using dielectrophoretic force.

However, internal research has shown that even with the exclusivity of the R, G, and B LED chips' shapes, the DEP force difference increases as the area difference between the oval and circular LED chips increases, resulting in a lower assembly rate due to a lower DEP force for the oval LED chips.

In particular, research is currently underway on the adoption of micro-LED displays in UHD (Ultra High Definition) TVs, such as 4K and 8K, as well as VR, AR, and XR. Micro LEDs used in these UHD TVs, VR, AR, and XR devices require a size of 20 µm or less, for example, 10 µm or less.

However, internal research has shown that to ensure exclusivity (the gap between the shape differences between the R, G, and B LED chips), the standard circular chip size is to be at least 42 µm to ensure exclusivity for the remaining two oval-shaped chips.

Consequently, internal research is facing the contradiction of not being able to reduce the size of the R, G, and B LED chips below 42 µm to ensure shape exclusivity. Therefore, the development of micro-LED size and DEP assembly technology that can be adopted in UHD TVs, VR, AR, and XR is urgently needed.

In particular, when designing the LED chip size to 20 µm or less, the difference in DEP force becomes even greater, which leads to a problem of low assembly rates.

### [Disclosure]

### [Technical Problem]

One of technical problems of the embodiment is to increase an assembling probability of R, G, B LED chips capable of self-emission of R, G, B colors by ensuring exclusiveness among the R, G, B LED chips while being a micro-LED size that can be employed in UHD TV, VR, AR, XR, and the like.

Also, one of technical problems of the embodiment is to increase an assembling probability while making DEP force uniform for LED chips for each color in a self-assembly method using dielectrophoresis (DEP).

### [Technical Solution]

An assembly substrate structure for a display pixel according to an embodiment may include a circular first assembly hole disposed in a first region of a predetermined assembly substrate, a second assembly hole disposed in a second region of the assembly substrate, and an elliptical third assembly hole disposed in a third region of the assembly substrate.

The first assembly hole, the second assembly hole, and the third assembly hole may each include a width in a first direction and a width in a second direction perpendicular to the first direction.

An increment of the width in the first direction of the second assembly hole and the third assembly hole may increase at a predetermined exclusive interval based on the width in the first direction of the first assembly hole.

A decrement of the width in the second direction of the second assembly hole and the third assembly hole may be such that the decrements intersect based on the width in the second direction of the first assembly hole.

The decrement of the width in the second direction of the second assembly hole may be greater than the decrement of the width in the second direction of the third assembly hole.

The width in the second direction of the second assembly hole may be smaller than the width in the second direction of the third assembly hole.

The second assembly hole may include an arc at an upper side and a lower side among a horizontal cross-section.

The upper side and the lower side among the horizontal cross-section of the second assembly hole may include a predetermined arc based on half of a length of the width in the first direction.

The horizontal cross-section of the second assembly hole may include a symmetrical shape with a constricted middle.

The horizontal cross-section of the second assembly hole (301b) may include a dumbbell shape with a constricted middle.

Also, a semiconductor light-emitting device package for a display pixel according to an embodiment may include a circular first semiconductor light-emitting device disposed in a first region of a predetermined assembly substrate, a second semiconductor light-emitting device disposed in a second region of the assembly substrate, and an elliptical third semiconductor light-emitting device disposed in a third region of the assembly substrate.

The first semiconductor light-emitting device, the second semiconductor light-emitting device, and the third semiconductor light-emitting device may each include a width in a first direction and a width in a second direction perpendicular to the first direction.

An increment of the width in the first direction of the second semiconductor light-emitting device and the third semiconductor light-emitting device may increase at a predetermined exclusive interval based on the width in the first direction of the first semiconductor light-emitting device.

A decrement of the width in the second direction of the second semiconductor light-emitting device and the third semiconductor light-emitting device may be such that the decrements intersect based on the width in the second direction of the first semiconductor light-emitting device.

The decrement of the width in the second direction of the second semiconductor light-emitting device may be greater than the decrement of the width in the second direction of the third semiconductor light-emitting device.

The width in the second direction of the second semiconductor light-emitting device may be smaller than the width in the second direction of the third semiconductor light-emitting device.

The second semiconductor light-emitting device may include an arc at an upper side and a lower side among a horizontal cross-section.

The upper side and the lower side among the horizontal cross-section of the second semiconductor light-emitting device may include a predetermined arc based on half of a length of the width in the first direction.

The horizontal cross-section of the second semiconductor light-emitting device may include a symmetrical shape with a constricted middle.

The horizontal cross-section of the second semiconductor light-emitting device (301b) may include a dumbbell shape with a constricted middle.

A display apparatus including a semiconductor light-emitting device according to an embodiment may include
any one of the assembly substrate structures for a display pixel.

Also, a display apparatus including a semiconductor light-emitting device according to an embodiment may include any one of the semiconductor light-emitting device packages for a display pixel.

### [Advantageous Effects]

According to an embodiment, there is a technical effect capable of increasing an assembling probability of R, G, B LED chips capable of self-emission of R, G, B colors by ensuring exclusiveness among the R, G, B LED chips while being a micro-LED size that can be employed in HD TV, VR, AR, XR, and the like.

Also, according to an embodiment, there is a technical effect capable of increasing an assembling probability while making DEP force uniform for LED chips for each color in a self-assembly method using dielectrophoresis (DEP).

For example, ① unlike the internal technology, even if the sizes of the LED chips are reduced to 30 *µ*m or less, an area difference between the circular first semiconductor light-emitting device (350R), which is a reference chip, and the remaining second semiconductor light-emitting device (350G) and third semiconductor light-emitting device (350B) having different shapes can be controlled to an area difference of about 10%.

Accordingly, according to the assembly substrate structure for a display pixel and the semiconductor light-emitting device package according to the embodiment, in simultaneous assembly of RGB chips, a DEP Force acting on each chip is uniformly controlled, so that there is a technical effect of increasing an assembly rate.

In addition, when applying the assembly substrate structure for a display pixel and the first semiconductor light-emitting device package according to the embodiment, an inclination angle (Θ) of a semiconductor light-emitting device at a misassembled position can be controlled to about 10° or more. Accordingly, in the case of the embodiment, the light-emitting device chip at the misassembled position is removed by itself by magnetic force to increase a correct assembly probability, and there is a technical effect capable of solving a screen effect problem in which an LED chip blocks an entrance of an assembly hole.

② In addition, when applying the semiconductor light-emitting device package according to the embodiment, a long-to-short axis ratio of the chips is controlled to an appropriate level, for example, 2.5 or less or 2.0 or less, so that a problem that the LED chip is broken in an LLO process can be solved.

③ Also, as the long-to-short axis ratio is controlled to about 2.5 or less, there is an effect that an assembly probability of being assembled in an assembly hole is increased. According to the embodiment, even when exclusiveness is increased by providing more difference in horizontal cross-sectional shapes in respective assembly holes among R, G, B LED chips, as the long-to-short axis ratio is controlled to about 2.5 or less, there is an effect that the assembling probability that the second and third semiconductor light-emitting devices are assembled in the second assembly hole and the third assembly hole, respectively, is increased.

④ Also, according to the embodiment, an area of an active layer, which is a light-emitting region, is increased by an increase in areas of the heterotypical second semiconductor light-emitting device (350G) and the elliptical third semiconductor light-emitting device (350B), so that there is an effect of improving luminance.

### [Description of Drawings]

FIG. 1 is an exemplary view of a living room of a house where a display apparatus according to an embodiment is disposed.
FIG. 2 is an enlarged view of a first panel region in the display apparatus of FIG. 1.
FIG. 3 is a cross-sectional view taken along line B1-B2 of region A2 of FIG. 2.
FIG. 4 is an exemplary view of a light-emitting device being assembled to a substrate by a self-assembly method according to an embodiment.
FIG. 5 is a partial enlarged view of region A3 of FIG. 4.
FIG. 6 is an exemplary view of a relationship of DEP force according to an inclination angle (Θ) on a surface of an assembly substrate.
FIG. 7A is a structural view of an assembly substrate according to an embodiment.
FIG. 7B is an exemplary view of a semiconductor light-emitting device disposed on the assembly substrate structure according to FIG. 7a.
FIG. 7C is an exemplary view of the assembly hole shown in FIG. 7a.
FIG. 8A is a plan view of a first assembly substrate structure for a display pixel (300A1) according to an embodiment.
FIG. 8B is an exemplary view showing each assembly hole shown in FIG. 8A in an overlapping manner.
FIG. 8C is an enlarged view of the second assembly hole (301b) shown in FIG. 8A.
FIG. 8D is an exemplary view of a first semiconductor light-emitting device package (350A) assembled on the first assembly substrate structure for a display pixel (300A1) shown in FIG. 8A.
FIG. 9A is a plan view of a second assembly substrate structure for a display pixel (300A2) according to an embodiment.
FIG. 9B is an exemplary view showing each assembly hole shown in FIG. 9A in an overlapping manner.

### [Mode for Invention]

Hereinafter, embodiments disclosed in the present specification will be described in detail with reference to the accompanying drawings. Suffixes 'module' and 'unit' for components used in the following description are given or used interchangeably in consideration of the ease of preparing the specification, and do not themselves have distinct meanings or roles. In addition, the accompanying drawings are for easy understanding of the embodiments disclosed in the present specification, and the technical idea disclosed in the present specification is not limited by the accompanying drawings. Furthermore, when an element such as a layer, region, or substrate is mentioned as being 'on' another component, this includes not only a case where it exists directly on another element but also a case where other intervening elements may exist between them.

Display apparatuses described in the present specification may include digital TVs, mobile phones, smart phones, laptop computers, digital broadcasting terminals, personal digital assistants (PDA), portable multimedia players (PMP), navigation systems, slate PCs, tablet PCs, ultra-books, desktop computers, and the like. However, the configuration according to the embodiments described in the present specification may also be applied to an apparatus capable of display, even if it is a new product form to be developed later.

Hereinafter, a semiconductor light-emitting device and a display apparatus including the same according to an embodiment will be described.

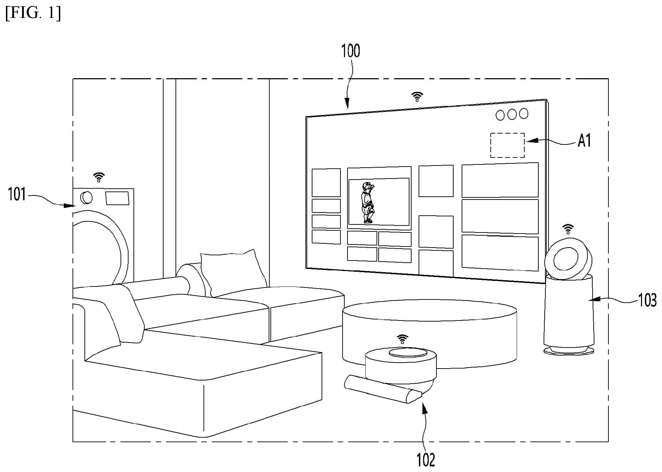

FIG. 1 shows a living room of a house where a display apparatus (100) according to an embodiment is disposed.

The display apparatus (100) of the embodiment may display states of various electronic products such as a washing machine (101), a robot cleaner (102), and an air purifier (103), may communicate with each electronic product based on IOT, and may control each electronic product based on setting data of a user.

The display apparatus (100) according to the embodiment may include a flexible display manufactured on a thin and flexible substrate. The flexible display may be bent or rolled like paper while maintaining characteristics of a conventional flat panel display.

Visual information in the flexible display may be implemented by independently controlling light emission of unit pixels arranged in a matrix form. A unit pixel means a minimum unit for implementing one color. A unit pixel of the flexible display may be implemented by a light-emitting device. In an embodiment, the light-emitting device may be a Micro-LED or a Nano-LED, but is not limited thereto.

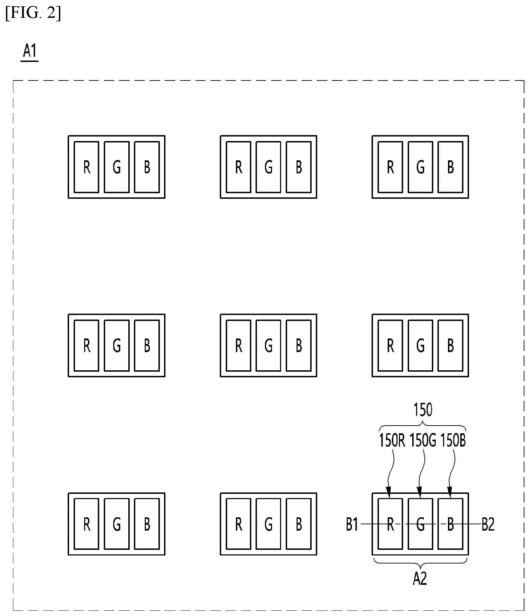

FIG. 2 is an enlarged view of a first panel region (A1) in the display apparatus of FIG. 1.

According to FIG. 2, the display apparatus (100) of the embodiment may be manufactured by mechanically and electrically connecting a plurality of panel regions, such as the first panel region (A1), by tiling.

The first panel region (A1) may include a plurality of light-emitting devices (150) disposed for each unit pixel.

For example, the unit pixel may include a first sub-pixel, a second sub-pixel, and a third sub-pixel. For example, a plurality of red light-emitting devices (150R) may be disposed in the first sub-pixel, a plurality of green light-emitting devices (150G) may be disposed in the second sub-pixel, and a plurality of blue light-emitting devices (150B) may be disposed in the third sub-pixel. The unit pixel may further include a fourth sub-pixel in which no light-emitting device is disposed, but this is not limited. Meanwhile, the light-emitting device (150) may be a semiconductor light-emitting device.

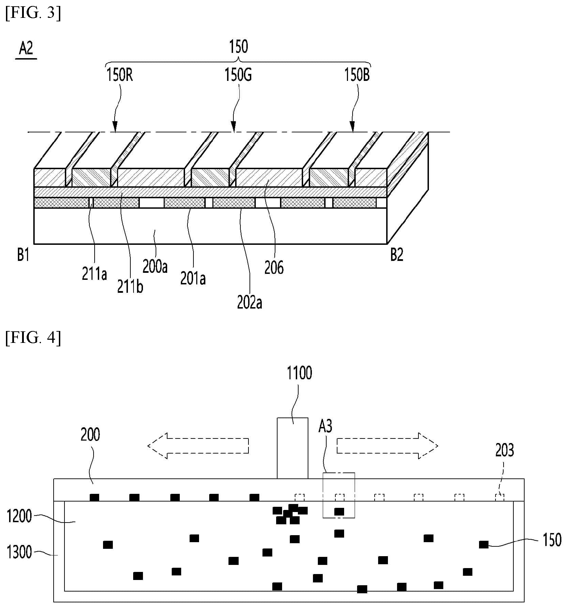

Next, FIG. 3 is a cross-sectional view taken along line B1-B2 of region A2 of FIG. 2.

Referring to FIG. 3, the display apparatus (100) of the embodiment may include a substrate (200a), wires (201a, 202a) spaced apart from each other, a first insulating layer (211a), a second insulating layer (211b), a third insulating layer (206), and a plurality of light-emitting devices (150).

The wires may include a first wire (201a) and a second wire (202a) spaced apart from each other. The first wire (201a) and the second wire (202a) may function as panel wires for applying power to the light-emitting device (150) in the panel, and in the case of self-assembly of the light-emitting device (150), may also perform an assembly electrode function for generating a dielectrophoretic force for assembly.

The wires (201a, 202a) may be formed of a transparent electrode (ITO) or may include a metal material having excellent electrical conductivity. For example, the wires (201a, 202a) may be formed of at least one of titanium (Ti), chromium (Cr), nickel (Ni), aluminum (Al), platinum (Pt), gold (Au), tungsten (W), molybdenum (Mo), or an alloy thereof.

A first insulating layer (211a) may be disposed between the first wire (201a) and the second wire (202a), and a second insulating layer (211b) may be disposed on the first wire (201a) and the second wire (202a). The first insulating layer (211a) and the second insulating layer (211b) may be an oxide film, a nitride film, or the like, but are not limited thereto.

The light-emitting devices (150) may include a red light-emitting device (150R), a green light-emitting device (150G), and a blue light-emitting device (150B) in order to form unit pixels (sub-pixels), respectively, but are not limited thereto, and red and green may be implemented by provided red and green phosphors.

The substrate (200) may be formed of glass or polyimide. Also, the substrate (200) may include a flexible material such as polyethylene naphthalate (PEN), polyethylene terephthalate (PET), and the like. Also, the substrate (200) may be a transparent material, but is not limited thereto. The substrate (200) may function as a support substrate in the panel, and may also function as a substrate for assembly during self-assembly of the light-emitting device.

The third insulating layer (206) may include a material having insulation and flexibility such as polyimide, PEN, PET, and the like, and may be formed integrally with the substrate (200) to form one substrate.

The third insulating layer (206) may be a conductive adhesive layer having adhesiveness and conductivity, and the conductive adhesive layer may be flexible to enable a flexible function of the display apparatus. For example, the third insulating layer (206) may be an anisotropic conductive film (ACF) or a conductive adhesive layer such as an anisotropic conductive medium, a solution containing conductive particles, and the like. The conductive adhesive layer may be a layer that is electrically conductive in a direction perpendicular to the thickness but electrically insulating in a direction horizontal to the thickness.

An interval between the wires (201a, 202a) is formed smaller than a width of the light-emitting device (150) and a width of the assembly hole (203), so that an assembly position of the light-emitting device (150) using an electric field can be more precisely fixed.

A third insulating layer (206) is formed on the wires (201a, 202a) to protect the wires (201a, 202a) from a fluid (1200) and prevent leakage of current flowing through the wires (201a, 202a). The third insulating layer (206) may be formed of an inorganic insulator such as silica, alumina, and the like, or an organic insulator as a single layer or multiple layers.

Also, the third insulating layer (206) may include a material having insulation and flexibility such as polyimide, PEN, PET, and the like, and may be formed integrally with the substrate (200) to form one substrate.

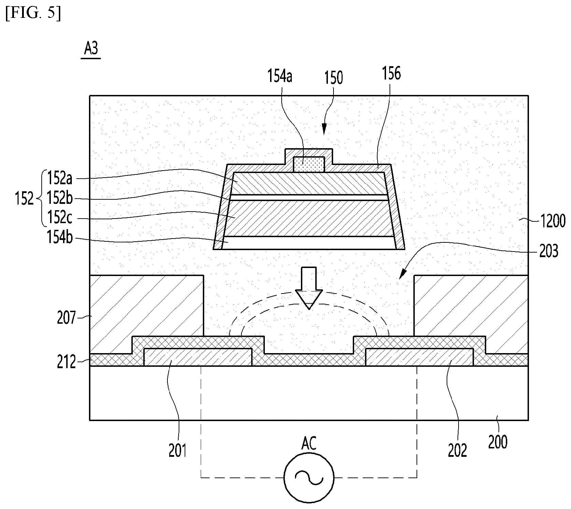

The third insulating layer (206) has a partition wall, and an assembly hole (203) may be formed by the partition wall. For example, the third insulating layer (206) may include an assembly hole (203) for inserting the light-emitting device (150) (refer to FIG. 4,5). Accordingly, during self-assembly, the light-emitting device (150) can be easily inserted into the assembly hole (203) of the third insulating layer (206). The assembly hole (203) may be called an insertion hole, a fixing hole, an alignment hole, or the like.

The assembly hole (203) may have a shape and size corresponding to a shape of a light-emitting device (150) to be assembled at a corresponding position. Accordingly, it is possible to prevent other light-emitting devices from being assembled or a plurality of light-emitting devices from being assembled in the assembly hole (203).

Next, FIG. 4 is a view showing an example in which a light-emitting device according to an embodiment is assembled to a substrate by a self-assembly method, and FIG. 5 is a partial enlarged view of region A3 of FIG. 4. FIG. 5 is a view in a state in which the region A3 is rotated by 180 degrees for convenience of description.

Based on FIGS. 4 and 5, an example in which a semiconductor light-emitting device according to an embodiment is assembled to a display panel by a self-assembly method using an electromagnetic field will be described.

An assembly substrate (200) to be described later may also function as a panel substrate in a display apparatus after assembly of the light-emitting device, but the embodiment is not limited thereto.

Referring to FIG. 4, the semiconductor light-emitting device (150) may be put into a chamber (1300) filled with a fluid (1200), and the semiconductor light-emitting device (150) may move toward the substrate (200) by a magnetic field generated from an assembly apparatus (1100). At this time, the light-emitting device (150) adjacent to the assembly hole (203) of the assembly substrate (200) may be assembled in the assembly hole (230) by a dielectrophoretic force by an electric field of assembly electrodes. The fluid (1200) may be water such as ultrapure water, but is not limited thereto. The chamber may be called a water tank, a container, a vessel, or the like.

After the semiconductor light-emitting device (150) is put into the chamber (1300), the assembly substrate (200) may be disposed on the chamber (1300). According to an embodiment, the assembly substrate (200) may be put into the chamber (1300).

Referring to FIG. 5, the semiconductor light-emitting device (150) may be implemented as a vertical semiconductor light-emitting device as shown, but is not limited thereto, and a horizontal light-emitting device may be employed.

The semiconductor light-emitting device (150) may include a magnetic layer (not shown) having a magnetic body. The magnetic layer may include a metal having magnetism such as nickel (Ni). Since the semiconductor light-emitting device (150) put into the fluid includes the magnetic layer, it can move toward the substrate (200) by a magnetic field generated from the assembly apparatus (1100). The magnetic layer may be disposed on an upper side, a lower side, or both sides of the light-emitting device.

The semiconductor light-emitting device (150) may include a passivation layer (156) surrounding an upper surface and side surfaces. The passivation layer (156) may be formed of an inorganic insulator such as silica, alumina, and the like through PECVD, LPCVD, a sputtering deposition method, and the like. Also, the passivation layer (156) may be formed through a method of spin coating an organic material such as a photoresist and a polymer material.

The semiconductor light-emitting device (150) may include a first conductivity type semiconductor layer (152a), a second conductivity type semiconductor layer (152c), and an active layer (152b) disposed therebetween. The first conductivity type semiconductor layer (152a) may be an n-type semiconductor layer, and the second conductivity type semiconductor layer (152c) may be a p-type semiconductor layer, but they are not limited thereto.

A first electrode may be connected to the first conductivity type semiconductor layer (152a), and a second electrode may be connected to the second conductivity type semiconductor layer (152c). For this purpose, partial regions of the first conductivity type semiconductor layer (152a) and the second conductivity type semiconductor layer (152c) may be exposed to the outside. Accordingly, in a manufacturing process of the display apparatus after the semiconductor light-emitting device (150) is assembled to the assembly substrate (200), a partial region of the passivation layer (156) may be etched.

The assembly substrate (200) may include a pair of a first assembly electrode (201) and a second assembly electrode (202) corresponding to each of the semiconductor light-emitting devices (150) to be assembled. The first assembly electrode (201) and the second assembly electrode (202) may be formed by multi-layering a single metal, a metal alloy, a metal oxide, or the like.

The first assembly electrode (201) and the second assembly electrode (202) may fix a semiconductor light-emitting device (150) put into a hole (203) by a dielectrophoretic force by emitting an electric field as an AC voltage is applied. An interval between the first assembly electrode (201) and the second assembly electrode (202) may be smaller than a width of the semiconductor light-emitting device (150) and a width of the assembly hole (203), and an assembly position of the semiconductor light-emitting device (150) using an electric field can be more precisely fixed.

An insulating layer (212) is formed on the first assembly electrode (201) and the second assembly electrode (202) to protect the first assembly electrode (201) and the second assembly electrode (202) from a fluid (1200) and prevent leakage of current flowing through the first assembly electrode (201) and the second assembly electrode (202). For example, the insulating layer (212) may be formed of an inorganic insulator such as silica, alumina, or an organic insulator as a single layer or multiple layers. The insulating layer (212) may have a minimum thickness for preventing damage to the first assembly electrode (201) and the second assembly electrode (202) during assembly of the semiconductor light-emitting device (150), and may have a maximum thickness for the semiconductor light-emitting device (150) to be stably assembled.

A partition wall (207) may be formed on top of the insulating layer (212). A partial region of the partition wall (207) may be located on top of the first assembly electrode (201) and the second assembly electrode (202), and the remaining region may be located on top of the assembly substrate (200).

Meanwhile, during manufacturing of the assembly substrate (200), an assembly hole (203) in which each of the semiconductor light-emitting devices (150) is coupled and assembled to the assembly substrate (200) may be formed by removing a part of the partition wall formed on the entire top of the insulating layer (212).

In the assembly substrate (200), an assembly hole (203) to which the semiconductor light-emitting devices (150) are coupled is formed, and a surface on which the assembly hole (203) is formed may contact the fluid (1200). The assembly hole (203) may guide an accurate assembly position of the semiconductor light-emitting device (150).

Meanwhile, the assembly hole (203) may have a shape and size corresponding to a shape of a semiconductor light-emitting device (150) to be assembled at a corresponding position. Accordingly, it is possible to prevent other semiconductor light-emitting devices from being assembled or a plurality of semiconductor light-emitting devices from being assembled in the assembly hole (203).

Referring again to FIG. 4, after the assembly substrate (200) is disposed in the chamber, an assembly apparatus (1100) applying a magnetic field may move along the assembly substrate (200). The assembly apparatus (1100) may be a permanent magnet or an electromagnet.

The assembly apparatus (1100) may move in a state in contact with the assembly substrate (200) to maximize an area affected by a magnetic field into the fluid (1200). According to an embodiment, the assembly apparatus (1100) may include a plurality of magnetic bodies or may include a magnetic body having a size corresponding to the assembly substrate (200). In this case, a moving distance of the assembly apparatus (1100) may be limited within a predetermined range.

The semiconductor light-emitting device (150) in the chamber (1300) may move toward the assembly apparatus (1100) and the assembly substrate (200) by a magnetic field generated by the assembly apparatus (1100).

Referring to FIG. 5, while moving toward the assembly apparatus (1100), the semiconductor light-emitting device (150) may enter and be fixed in the assembly hole (203) by a dielectrophoretic force (DEP force) formed by an electric field of assembly electrodes of the assembly substrate.

Specifically, assembly wirings (201, 202) form an electric field by an AC power source, and a dielectrophoretic force may be formed between the assembly wirings (201, 202) by the electric field. The semiconductor light-emitting device (150) can be fixed in the assembly hole (203) on the substrate (200) by the dielectrophoretic force.

At this time, a predetermined solder layer (not shown) is formed between the light-emitting device (150) assembled on the assembly hole (203) of the substrate (200) and the assembly electrode to improve a coupling force of the light-emitting device (150).

Also, after assembly, a molding layer (not shown) may be formed in the assembly hole (203) of the assembly substrate (200). The molding layer may be a transparent resin or a resin containing a reflective material or a scattering material.

By the self-assembly method using the above-described electromagnetic field, a time required for each of the semiconductor light-emitting devices to be assembled to the substrate can be sharply shortened, so that a large-area high-pixel display can be implemented more quickly and economically.

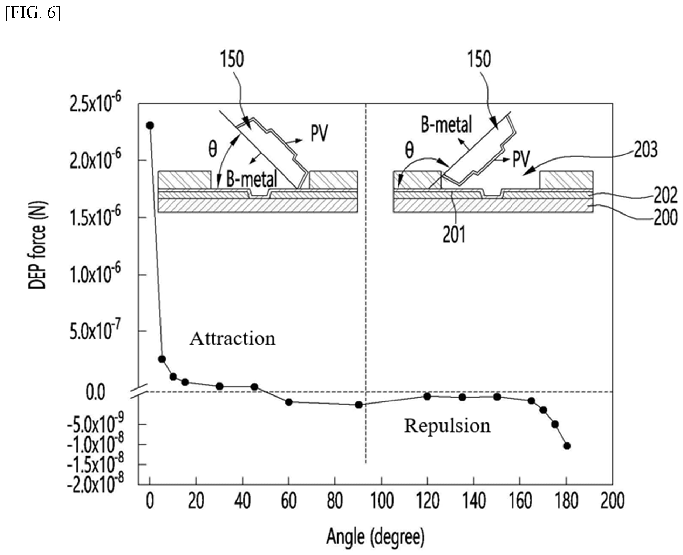

Next, FIG. 6 is an exemplary view of a relationship of DEP force according to an inclination angle (Θ) on a surface of an assembly substrate (200) of a micro-LED (150) on a surface of an assembly hole (203) in an embodiment.

A micro-LED, which is the semiconductor light-emitting device (150) according to an embodiment, may include a back metal layer (B-metal) including a magnetic layer on a back surface thereof, and may include a passivation layer (PV) on an upper surface thereof.

According to an embodiment, various movements of the micro-LED by a DEP force generated by assembly electrodes (201, 202) when the micro-LED (150) approaches the assembly hole (203) at various angles (Θ) relative to the surface of the assembly substrate (200) were investigated.

Referring to FIG. 6, in a cross-sectional view (top left) of a 3D model where an inclination angle (Θ) range is 0-90°, a metal layer (B-metal) on the back surface of the micro-LED (150) receives an attractive force by a positive (+) DEP force and moves in a direction of assembly electrodes (201, 202).

On the other hand, in a cross-sectional view (top right) of a 3D model where an inclination angle (Θ) range is 90-180°, the metal layer (B-metal) on the back surface of the micro-LED (150) receives a repulsive force by a negative (-) DEP force so that a passivation layer (PV) on top of the micro-LED moves in a direction of assembly electrodes (201, 202).

Meanwhile, as can be seen in FIG. 6, dielectrophoretic assembly by a DEP force may significantly vary in DEP force according to a height of the assembly hole (203) and an inclination angle of the semiconductor light-emitting device (150) with the assembly substrate (200) in the assembly hole (203). For example, even if the inclination angle (Θ) range is 0-90°, there is a DEP force selectivity in which the DEP force is significantly reduced if the inclination angle (Θ) exceeds about 10° or more.

For example, when a light-emitting device chip not corresponding to an assembly hole is on the assembly hole, the inclination angle thereof can be controlled to be about 10° or more, and in this case, since a magnetic force applied to the light-emitting device chip by a magnet is greater than a DEP force applied to the light-emitting device chip, there is a technical effect of increasing a correct assembly probability as the light-emitting device chip at a misassembled position is removed by itself.

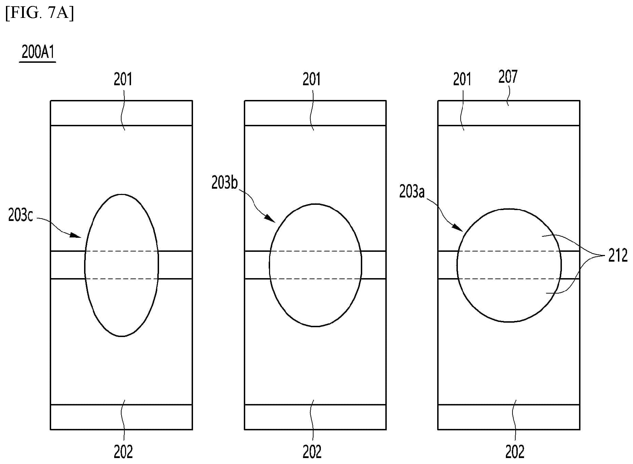

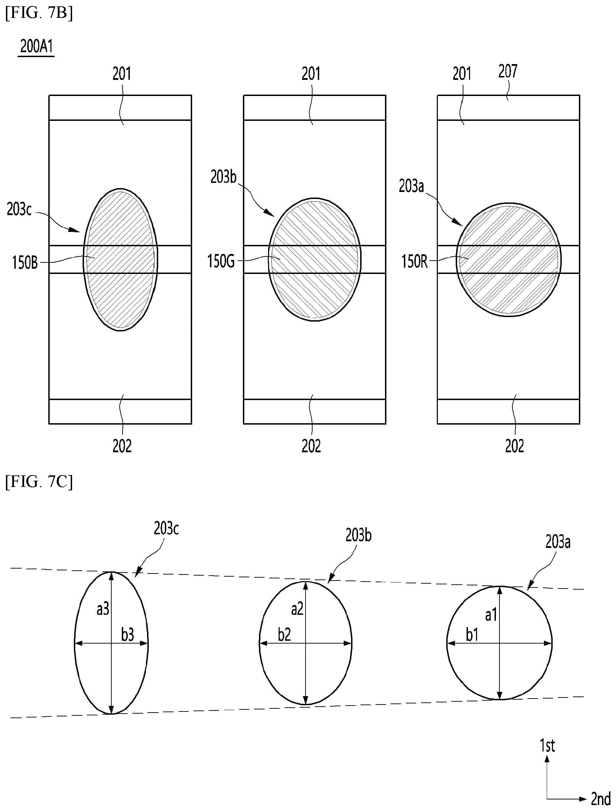

Next, FIG. 7A is an assembly substrate structure according to an embodiment, and FIG. 7B is an exemplary view of semiconductor light-emitting devices disposed on the assembly substrate structure according to FIG. 7A. Also, FIG. 7C is an exemplary view of the assembly hole shown in FIG. 7A.

In an embodiment, an assembly hole of a substrate may have a shape and size corresponding to a shape of a semiconductor light-emitting device to be assembled at a corresponding position. Accordingly, it is possible to prevent other semiconductor light-emitting devices from being assembled or a plurality of semiconductor light-emitting devices from being assembled in the assembly hole.

Also, according to undisclosed internal technology, simultaneous assembly of an R micro-LED chip, a G micro-LED chip, and a B LED chip using dielectrophoresis is being studied.

However, in order for the R, G, B LED chips to be accurately assembled in respective assembly holes, research on chip shape exclusiveness for differentiating horizontal cross-sectional shapes of the R, G, B LED chips is being conducted.

For example, referring to FIG. 7A, an assembly substrate structure (200A1) according to an embodiment may include a plurality of first assembly electrodes (201) and second assembly electrodes (202) spaced apart from each other.

Also, an embodiment may include a partition wall (207) disposed on each of the assembly electrodes (201, 202).

The partition wall (207) may include a first assembly hole (203a), a second assembly hole (203b), and a third assembly hole (203c) from which a part is removed in consideration of a shape of a light-emitting device to be assembled. An insulating layer (212) may be exposed by the first assembly hole (203a), the second assembly hole (203b), and the third assembly hole (203c).

A horizontal cross-section of the first assembly hole (203a) may be circular, and horizontal cross-sections of the second assembly hole (203b) and the third assembly hole (203c) may be elliptical.

Referring to FIG. 7B, a first semiconductor light-emitting device (150R), a second semiconductor light-emitting device (150G), and a third semiconductor light-emitting device (150B) may be assembled in the first assembly hole (203a), the second assembly hole (203b), and the third assembly hole (203c), respectively. The first semiconductor light-emitting device (150R) may be an R LED chip, the second semiconductor light-emitting device (150G) may be a G LED chip, and the third semiconductor light-emitting device (150B) may be a B LED chip.

A horizontal cross-section of the first assembly hole (203a) may be circular, and horizontal cross-sections of the second assembly hole (203b) and the third assembly hole (203c) may be elliptical.

Specifically, referring to FIG. 7C, the first assembly hole (203a) may include a first-direction first width (a1) based on a first axis (1st) and a second-direction first width (b1) based on a second axis (2nd) perpendicular to the first axis, and the first-direction first width (a1) and the second-direction first width (b1) may be the same, but are not limited thereto.

Next, the second assembly hole (203b) may include a first-direction second width (a2) and a second-direction second width (b2), and the third assembly hole (203c) may include a first-direction third width (a3) and a second-direction third width (b3).

For example, the first assembly hole (203a) may include a circular cross-section in which a first-direction first width (a1) and a second-direction first width (b1) are each 38 µm.

At this time, the second assembly hole (203b) and the third assembly hole (203c) may have a predetermined exclusive interval based on the first assembly hole (203a). For example, the second assembly hole (203b) and the third assembly hole (203c) may be such that a long axis, for example, a first direction width increases, and a short axis, for example, a second direction width decreases, at an exclusive interval based on the first assembly hole (203a). The exclusive interval may be about 5 µm to 10 µm, but is not limited thereto.

For example, when the first assembly hole (203a) has a circular cross-section in which a first-direction first width (a1) and a second-direction first width (b1) are each 38 µm and an exclusive interval is 7 µm, a first-direction second width (a2) of the second assembly hole (203b) may be 45 µm, and a second-direction second width (b2) may be 31 µm.

Also, a first-direction third width (a3) of the third assembly hole (203c) may be 52 µm, and a second-direction third width (b3) may be 24 µm, but they are not limited thereto.

As described above, micro-LED display adoption for UHD (Ultra High Definition) TVs such as 4K, 8K or VR, AR, XR, and the like is being studied recently, and micro-LEDs adopted for such UHD TVs or VR, AR, XR, and the like are required to have a size of 20 µm or less, for example, 10 µm or less.

However, in the internal technology, it is being studied that a size of a circular reference chip should be secured at least 42 µm or more in order to secure exclusiveness, which is an interval of shape difference among R, G, B LED chips, to implement the remaining two types of elliptical chips with exclusiveness.

Accordingly, according to the internal technology, in order to secure shape exclusiveness among the R, G, B LED chips, a contradiction of not being able to reduce the sizes of the R, G, B LED chips to less than 42 µm is being faced, and development of micro-LED sizes and DEP assembly technology that can be adopted for UHD TVs or VR, AR, XR, and the like is urgently needed.

Specifically, when the exclusive structure of the internal technology is applied, the following problems have been internally studied.

① First, in order to improve DEP selectivity by increasing a DEP force deviation in each assembly hole among R, G, B LED chips, exclusiveness was increased by providing more difference in horizontal cross-sectional shapes of the R, G, B LED chips. However, as the sizes of the chips become smaller, an area difference between the circular first semiconductor light-emitting device (150R), which is a reference chip, and elliptical semiconductor light-emitting devices, particularly an elliptical third semiconductor light-emitting device (150B), appears increasingly larger.

For example, when a size of the circular first semiconductor light-emitting device (150R) is 38 µm and an exclusive interval is set to 7 µm, areas of an elliptical second semiconductor light-emitting device (150G) and an elliptical third semiconductor light-emitting device (150B) are at levels of about 96% and about 86% relative to an area of the circular first semiconductor light-emitting device (150R), respectively.

However, when a size of the circular first semiconductor light-emitting device (150R) is 25 µm and an exclusive interval is set to 7 µm, areas of the elliptical second semiconductor light-emitting device (150G) and the elliptical third semiconductor light-emitting device (150B) are at levels of about 92% and about 68% relative to the area of the circular first semiconductor light-emitting device (150R), respectively, such that a size ratio of the elliptical third semiconductor light-emitting device (150B) decreases a lot.

In particular, when the size of the circular first semiconductor light-emitting device (150R) is 21 µm and the exclusive interval is set to 7 µm, the areas of the elliptical second semiconductor light-emitting device (150G) and the elliptical third semiconductor light-emitting device (150B) decrease to levels of about 88% and about 49% relative to the area of the circular first semiconductor light-emitting device (150R), respectively, and the size ratio of the elliptical third semiconductor light-emitting device (150B) sharply decreases.

Meanwhile, in the simultaneous assembly of RGB chips, it is helpful to increase the assembly rate that the DEP forces acting on each of the chips are equal.

However, the DEP force corresponds to the lower area of the LED chip, and is also closely related to the inclined inclination angle of the LED chip in the assembly hole as described above based on FIG. 6.

However, as described above based on FIGS. 7A to 7C, as the area difference between the circular first semiconductor light-emitting device (150R) and the elliptical third semiconductor light-emitting device (150B) sharply occurs, a large difference in the DEP force applied to each LED chip appears due to the area ratio difference, and it has been studied that this becomes more problematic when the size of the LED chip becomes smaller than 30 µm.

Also, according to internal research, even if there is exclusiveness in the shapes of the R, G, B LED chips, the applied DEP forces are similar or the difference is not large, so there is a screen effect problem in which other LED chips block the entrance of the assembly hole. For example, a screen effect problem in which a G LED chip or a B LED chip blocks the entrance of the assembly hole occurred in the assembly hole for the R LED chip, and accordingly, a problem of deterioration of DEP selectivity between LED chips occurs, so there is a problem that the simultaneous assembly rate for the three-color R, G, B chips is low.

For example, in the internal technology, when the elliptical second semiconductor light-emitting device (150G) is located in the circular first assembly hole (230a), the inclination angle (Θ) with the assembly substrate (200) was studied to be about 9.76°.

Also, in the internal technology, when the elliptical third semiconductor light-emitting device (150B) is located in the circular first assembly hole (230a), the inclination angle (Θ) with the assembly substrate (200) was studied to be about 9.45°.

However, as can be seen in FIG. 6, the DEP force significantly decreases and there is a DEP force selectivity only when the inclination angle (Θ) range exceeds about 10° or more.

However, in the case of the internal technology, when the elliptical second semiconductor light-emitting device (150G) or the elliptical third semiconductor light-emitting device (150B) is located in the circular first assembly hole (230a), the inclination angles (Θ) were studied to be about 9.76° and about 9.45°, respectively, which are near 10°.

Accordingly, the DEP forces applied to the corresponding elliptical second and third light-emitting device chips (150G, 150B), respectively, are at a considerable level, and the DEP force applied to the chips in misassembled positions may be greater than the magnetic force applied by the magnet.

Accordingly, in the case of the internal technology, it may be difficult to increase the correct assembly probability because the light-emitting device chip at the misassembled position is not removed by itself by the magnetic force, and even if there is exclusiveness in the shapes of the R, G, B LED chips, the applied DEP forces are similar or the difference is not large, so there is a screen effect problem in which other LED chips block the entrance of the assembly hole. For example, a screen effect problem in which a G LED chip or a B LED chip blocks the entrance of the assembly hole occurred in the assembly hole for the R LED chip, and accordingly, a problem of deterioration of DEP selectivity between LED chips occurs, so there is a problem that the simultaneous assembly rate is low.

② Also, as the size of the chip becomes smaller, the aspect ratio (long-to-short axis ratio) of the elliptical third semiconductor light-emitting device (150B) increases. For example, in the case of a 38 µm circular chip, the aspect ratio (a3/b3) of the elliptical third semiconductor light-emitting device (150B) is about 2.17, but in the case of a 21 µm circular chip, the aspect ratio (a3/b3) of the elliptical third semiconductor light-emitting device (150B) greatly increases up to about 5.0. When the aspect ratio becomes large like this, there is a problem that the chip is easily broken in an LLO (Laser Lift Off) process of the LED chip or the like.

③ Also, due to the increase in the aspect ratio, the assembly probability of being assembled in the assembly hole becomes low. For example, the description will be made assuming that the assembly probability in the case of a circular chip is 100%.

In a case where exclusiveness is increased by providing more difference in horizontal cross-sectional shapes of R, G, B LED chips to improve DEP selectivity by increasing the DEP force deviation in each assembly hole among the R, G, B LED chips, there is a problem that an assembling probability in the assembly hole decreases due to the shapes of the elliptical LED chip with a long axis and the elliptical assembly hole with a long axis.

For example, when the size of the circular first semiconductor light-emitting device (150R) is 38 µm and the exclusive interval is set to 7 µm, assuming an area ratio of an elliptical chip having a long axis of 38 µm relative to the circular first semiconductor light-emitting device (150R) of 38 µm size, the area ratio is about 46%, so the assembly probability also decreases to about 46%.

In particular, when the size of the circular first semiconductor light-emitting device (150R) is 21 µm and the exclusive interval is set to 7 µm, assuming an area ratio of an elliptical chip having a long axis of 21 µm relative to the circular first semiconductor light-emitting device (150R) of 21 µm size, the area ratio is about 18%, so there is a problem that the assembly probability sharply decreases to about 18%.

④ Also, due to the decrease in the area of the elliptical third semiconductor light-emitting device (150B), the area of an active layer, which is a light-emitting region, becomes relatively small, resulting in a problem of lower luminance.

Accordingly, one of the technical objects of the embodiments is to provide an assembly substrate structure for a semiconductor light-emitting device for a pixel, a semiconductor light-emitting device for a pixel, and a display apparatus including the same, which can increase the simultaneous assembly probability of R, G, B LED chips capable of self-emitting R, G, B colors while having a micro-LED size that can be adopted for UHD TVs, VR, AR, XR, and the like, as well as securing exclusiveness among the R, G, B LED chips.

In addition, another technical object of the embodiments is to provide an assembly substrate structure for a semiconductor light-emitting device, a semiconductor light-emitting device for a pixel, and a display apparatus including the same, which can increase an assembling probability while increasing DEP selectivity for LED chips of each color in a self-assembly method using dielectrophoresis (DEP).

Hereinafter, specific features of embodiments for solving the technical problems of the present invention will be described in detail with reference to the drawings.

### <First Embodiment>

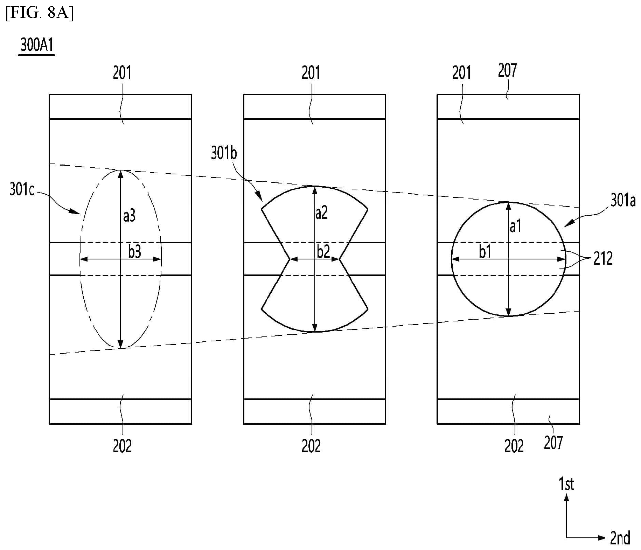

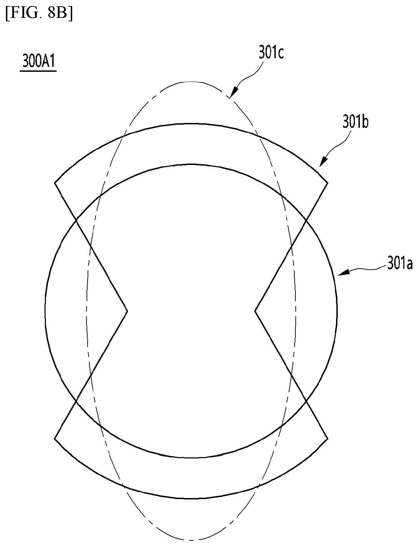

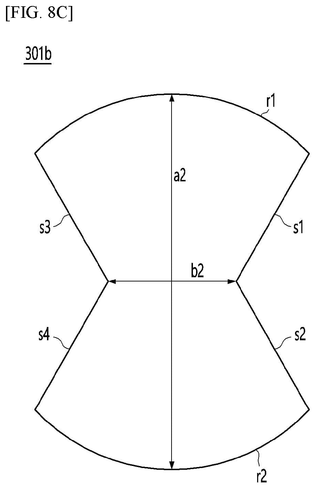

FIG. 8A is a plan view of a first assembly substrate structure (300A1) for a display pixel according to an embodiment, FIG. 8B is an exemplary view showing each assembly hole shown in FIG. 8A in an overlapping manner, and FIG. 8C is an enlarged view of a second assembly hole (301b) shown in FIG. 8A.

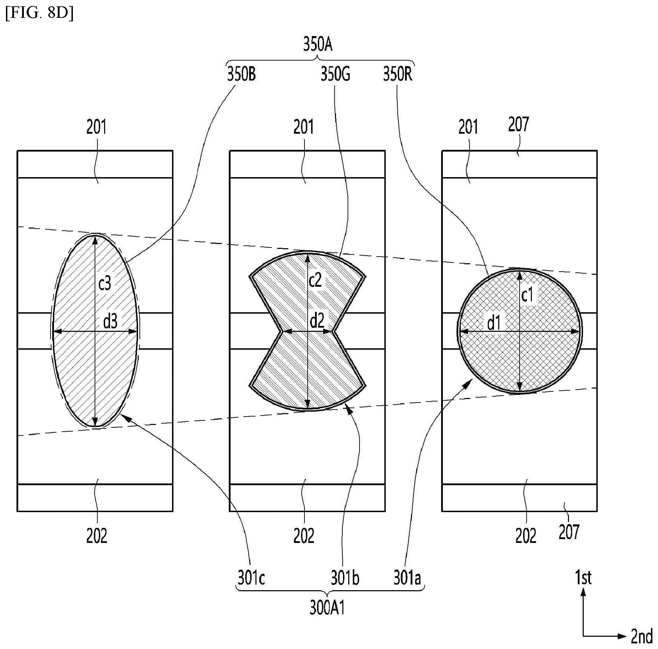

FIG. 8D is an exemplary view of a first semiconductor light-emitting device package (350A) assembled on the first assembly substrate structure (300A1) for a display pixel shown in FIG. 8A.

Hereinafter, the 'assembly substrate structure for a display pixel' will be abbreviated as an 'assembly substrate structure'.

Referring to FIG. 8A, a first assembly substrate structure (300A1) according to an embodiment may include a plurality of first assembly electrodes (201) and second assembly electrodes (202) spaced apart from each other, and an assembly partition wall (207) disposed on each of the assembly electrodes (201, 202).

The assembly partition wall (207) may include a first assembly hole (301a), a second assembly hole (301b), and a third assembly hole (301c) from which a part is removed in consideration of a shape of a light-emitting device to be assembled. An insulating layer (212) may be exposed by the first assembly hole (301a), the second assembly hole (301b), and the third assembly hole (301c).

A horizontal cross-section of the first assembly hole (301a) may be circular, and a horizontal cross-section of the third assembly hole (301c) may be elliptical. At this time, a horizontal cross-section of the second assembly hole (301b) may be heterotypical.

For example, the horizontal cross-section of the second assembly hole (301b) may be neither circular nor elliptical.

For example, upper and lower sides of the horizontal cross-section of the second assembly hole (301b) may include a predetermined arc with half of a long axis length.

For example, the horizontal cross-section of the second assembly hole (301b) may have a symmetrical shape with a narrow middle. For example, the horizontal cross-section of the second assembly hole (301b) may have a dumbbell shape with a narrow middle, but is not limited thereto.

Next, FIG. 8D is an exemplary view of a first semiconductor light-emitting device package (350A) assembled on the first assembly substrate structure (300A1) for a display pixel shown in FIG. 8A.

Referring to FIG. 8D, a first semiconductor light-emitting device (350R), a second semiconductor light-emitting device (350G), and a third semiconductor light-emitting device (350B) may be assembled in the first assembly hole (301a), the second assembly hole (301b), and the third assembly hole (301c), respectively. The first semiconductor light-emitting device (350R) may be an R LED chip, the second semiconductor light-emitting device (350G) may be a G LED chip, and the third semiconductor light-emitting device (350B) may be a B LED chip, but are not limited thereto.

Shapes of the first semiconductor light-emitting device (350R), the second semiconductor light-emitting device (350G), and the third semiconductor light-emitting device (350B) may correspond to shapes of the first assembly hole (301a), the second assembly hole (301b), and the third assembly hole (301c), respectively.

Hereinafter, the description will focus on the first assembly substrate structure (300A1) for a display pixel, and these features may also be applied to the first semiconductor light-emitting device package (350A) assembled on the first assembly substrate structure (300A1) for a display pixel.

Referring again to FIG. 8A, the first assembly hole (301a) may include a first-direction first width (a1) based on a first axis (1st) and a second-direction first width (b1) based on a second axis (2nd) perpendicular to the first axis, and the first-direction first width (a1) and the second-direction first width (b1) may be the same, but are not limited thereto.

Next, the second assembly hole (301b) may include a first-direction second width (a2) and a second-direction second width (b2), and the third assembly hole (301c) may include a first-direction third width (a3) and a second-direction third width (b3).

For example, the first assembly hole (301a) may include a circular cross-section in which a first-direction first width (a1) and a second-direction first width (b1) are each 25 µm.

In the first assembly substrate structure (300A1) for a display pixel, an increment in a long-axis direction length of the second assembly hole (301b) and the third assembly hole (301c) based on the circular first assembly hole (301a) may have a constant exclusive interval.

On the other hand, in the first assembly substrate structure (300A1) for a display pixel, a decrement in a short-axis length of the second assembly hole (301b) and the third assembly hole (301c) based on the circular first assembly hole (301a) may be crossed and decreased. For example, the decrement in the short-axis direction of the second assembly hole (301b) may be greater than the decrement in the short-axis direction of the third assembly hole (301c). Accordingly, the second width (b2) in the short-axis direction of the second assembly hole (301b) may be smaller than the third width (b3) in the short-axis direction of the third assembly hole (301c).

For example, the second assembly hole (301b) and the third assembly hole (301c) may be increased at a regular exclusive interval based on the first assembly hole (301a) in a first direction (1st), which is a long axis.

For example, the second assembly hole (301b) and the third assembly hole (301c) may have a regular exclusive interval that increases by an exclusive interval based on the first assembly hole (301a) in the first direction (1st), which is a long axis.

For example, the second assembly hole (301b) and the third assembly hole (301c) may increase in a long axis, for example, a first direction width, at an exclusive interval based on the first assembly hole (301a). The exclusive interval may be about 5 µm to 10 µm, but is not limited thereto.

For example, when the first assembly hole (301a) has a circular cross-section in which a first-direction first width (a1) and a second-direction first width (b1) are each 25 µm and an exclusive interval is 7 µm, a first-direction second width (a2) of the second assembly hole (301b) may be 32 µm, and a first-direction third width (a3) of the third assembly hole (301c) may be 39 µm, but they are not limited thereto.

On the other hand, the second assembly hole (301b) and the third assembly hole (301c) may have an irregular exclusive interval based on the first assembly hole (301a) in a second direction (2nd), which is a short axis.

For example, a decrement in the short-axis direction of the second assembly hole (301b) may be greater than a decrement in the short-axis direction of the third assembly hole (301c). Accordingly, the second width (b2) in the short-axis direction of the second assembly hole (301b) may be smaller than the third width (b3) in the short-axis direction of the third assembly hole (301c).

For example, the short-axis length (b2) of the second assembly hole (301b) may be smaller than the short axis (b3) of the third assembly hole (301c).

For example, when the first assembly hole (301a) has a circular cross-section in which a first-direction first width (a1) and a second-direction first width (b1) are each 25 µm and an exclusive interval is 7 µm, a second-direction third width (b3) of the third assembly hole (301c) may be 18 µm, and a second-direction second width (b2) of the second assembly hole (301b) may be 11 µm.

FIG. 8C is an enlarged view of the second assembly hole (301b) shown in FIG. 8A.

In the first assembly substrate structure (300A1) for a display pixel, a horizontal cross-section of the first assembly hole (301a) may be circular, and a horizontal cross-section of the third assembly hole (301c) may be elliptical.

On the other hand, the horizontal cross-section of the second assembly hole (301b) may be heterotypical.

For example, upper and lower sides of the horizontal cross-section of the second assembly hole (301b) may include a predetermined arc with half of a long axis length.

For example, the second assembly hole (301b) may include a first curve (r1) and a second curve (r2) at an upper end and a lower end in a long axis direction, respectively, may include a first line (s1) and a second line (s2) connecting both ends of a short axis and both ends of the first curve (r1), and may include a third line (s3) and a fourth line (s4) connecting both ends of the short axis and both ends of the second curve (r2).

The first curve (r1) and the second curve (r2) may be in an arc shape, but are not limited thereto.

The first to fourth lines (s1, s2, s3, s4) may be straight lines, but are not limited thereto.

Continuing to refer to FIG. 8D, a first semiconductor light-emitting device (350R), a second semiconductor light-emitting device (350G), and a third semiconductor light-emitting device (350B) may be assembled in the first assembly hole (301a), the second assembly hole (301b), and the third assembly hole (301c), respectively.

The above features of the first assembly substrate structure (300A1) for a display pixel may also be applied to the first semiconductor light-emitting device package (350A).

For example, referring again to FIG. 8A, the first semiconductor light-emitting device (350R) may include a first-direction first width (c1) based on a first axis (1st) and a second-direction first width (d1) based on a second axis (2nd) perpendicular to the first axis, and the first-direction first width (c1) and the second-direction first width (d1) may be the same, but are not limited thereto.

Next, the second semiconductor light-emitting device (350G) may include a first-direction second width (c2) and a second-direction second width (d2), and the third semiconductor light-emitting device (350B) may include a first-direction third width (c3) and a second-direction third width (d3).

For example, the first semiconductor light-emitting device (350R) may include a circular cross-section in which a first-direction first width (c1) and a second-direction first width (d1) are each 25 µm.

In the first semiconductor light-emitting device package (350A), an increment in a long-axis direction length of the second semiconductor light-emitting device (350G) and the third semiconductor light-emitting device (350B) based on the circular first semiconductor light-emitting device (350R) may have a constant exclusive interval.

On the other hand, in the first semiconductor light-emitting device package (350A), a decrement in a short-axis length of the second semiconductor light-emitting device (350G) and the third semiconductor light-emitting device (350B) based on the circular first semiconductor light-emitting device (350R) may be crossed and decreased. For example, a decrement in the short-axis direction of the second semiconductor light-emitting device (350G) may be greater than a decrement in the short-axis direction of the third semiconductor light-emitting device (350B). Accordingly, the second width (d2) in the short-axis direction of the second semiconductor light-emitting device (350G) may be smaller than the third width (d3) in the short-axis direction of the third semiconductor light-emitting device (350B).

For example, the second semiconductor light-emitting device (350G) and the third semiconductor light-emitting device (350B) may be increased at a regular exclusive interval based on the first semiconductor light-emitting device (350R) in a first direction (1st), which is a long axis.

For example, the second semiconductor light-emitting device (350G) and the third semiconductor light-emitting device (350B) may have a regular exclusive interval that increases by an exclusive interval based on the first semiconductor light-emitting device (350R) in the first direction (1st), which is a long axis.

For example, the second semiconductor light-emitting device (350G) and the third semiconductor light-emitting device (350B) may increase in a long axis, for example, a first direction width, at an exclusive interval based on the first semiconductor light-emitting device (350R). The exclusive interval may be about 5 µm to 10 µm, but is not limited thereto.

For example, when the first semiconductor light-emitting device (350R) has a circular cross-section in which a first-direction first width (c1) and a second-direction first width (d1) are each 25 µm and an exclusive interval is 7 µm, a first-direction second width (c2) of the second semiconductor light-emitting device (350G) may be 32 µm, and a first-direction third width (c3) of the third semiconductor light-emitting device (350B) may be 39 µm, but they are not limited thereto.

On the other hand, the second semiconductor light-emitting device (350G) and the third semiconductor light-emitting device (350B) may have an irregular exclusive interval based on the first semiconductor light-emitting device (350R) in a second direction (2st), which is a short axis.

For example, a decrement in the short-axis direction of the second semiconductor light-emitting device (350G) may be greater than a decrement in the short-axis direction of the third semiconductor light-emitting device (350B). Accordingly, the second width (d2) in the short-axis direction of the second semiconductor light-emitting device (350G) may be smaller than the third width (d3) in the short-axis direction of the third semiconductor light-emitting device (350B).

For example, a short-axis length (d2) of the second semiconductor light-emitting device (350G) may be smaller than a short axis (d3) of the third semiconductor light-emitting device (350B).

For example, when the first semiconductor light-emitting device (350R) has a circular cross-section in which a first-direction first width (c1) and a second-direction first width (d1) are each 25 µm and an exclusive interval is 7 µm, a second-direction third width (d3) of the third semiconductor light-emitting device (350B) may be 18 µm, and a second-direction second width (d2) of the second semiconductor light-emitting device (350G) may be 11 µm.

Also, for example, when the first semiconductor light-emitting device (350R) has a circular cross-section in which a first-direction first width (c1) and a second-direction first width (d1) are each 21 µm and an exclusive interval is 7 µm, a width in a long-axis direction may be increased by the exclusive interval. For example, a first-direction second width (c2) of the second semiconductor light-emitting device (350G) may be 28 µm, and a first-direction third width (c3) of the third semiconductor light-emitting device (350B) may be 35 µm, but they are not limited thereto.

On the other hand, a width in a short-axis direction may be crossed and decreased. For example, when the first semiconductor light-emitting device (350R) has a circular cross-section in which a first-direction first width (c1) and a second-direction first width (d1) are each 21 µm and an exclusive interval is 7 µm, in the case of the width in the short-axis direction, a second-direction third width (d3) of the third semiconductor light-emitting device (350B) may be 14 µm, and a second-direction second width (d2) of the second semiconductor light-emitting device (350G) may be 7 µm.

Hereinafter, technical effects according to the first assembly substrate structure (300A1) for a display pixel according to an embodiment will be described in detail. Also, these technical effects may be applied to the first semiconductor light-emitting device package (350A) according to an embodiment.

① First, unlike the internal technology, even if the sizes of the LED chips become smaller than 30 µm, an area difference between the circular first semiconductor light-emitting device (350R), which is a reference chip, and the remaining second semiconductor light-emitting device (350G) and third semiconductor light-emitting device (350B) having different shapes can be controlled such that a DEP force is at a uniform level.

For example, when the size of the circular first semiconductor light-emitting device (350R) is 25 µm and an exclusive interval is set to 7 µm, it was studied that areas of the heterotypical second semiconductor light-emitting device (350G) and the elliptical third semiconductor light-emitting device (350B) are about 110.45% and about 112.32% relative to the area of the circular first semiconductor light-emitting device (350R), respectively, so that the areas rather increase, but an area difference of about 10% occurs.

Also, even when the size of the circular first semiconductor light-emitting device (350R) is 21 µm and the exclusive interval is set to 7 µm, it was studied that areas of the heterotypical second semiconductor light-emitting device (350G) and the elliptical third semiconductor light-emitting device (350B) are at levels of about 104.8% and about 111.11% relative to the area of the circular first semiconductor light-emitting device (350R), respectively, and an area difference of about 10% occurs.

Accordingly, according to the first assembly substrate structure (300A1) for a display pixel and/or the first semiconductor light-emitting device package (350A) according to the embodiment, there is a technical effect of increasing an assembly rate as the DEP Force acting on each of the chips is uniformly controlled in simultaneous assembly of RGB chips.

Also, as can be seen in FIG. 6 above, when an inclination angle (Θ) range of the LED chip in the assembly hole exceeds about 10° or more, a DEP force significantly decreases and there is a DEP force selectivity.

Meanwhile, in the case of the internal technology, when the elliptical second semiconductor light-emitting device (150G) or the elliptical third semiconductor light-emitting device (150B) is located in the circular first assembly hole (230a), inclination angles (Θ) were studied to be about 9.76° and about 9.45°, respectively, which are less than 10°.

Accordingly, the DEP forces applied to the corresponding elliptical second and third light-emitting device chips (150G, 150B), respectively, are at a considerable level, and the DEP force applied to the chips in misassembled positions may be greater than the magnetic force applied by the magnet.

Accordingly, in the case of the internal technology, it may be difficult to increase the correct assembly probability because the light-emitting device chip at the misassembled position is not removed by itself by the magnetic force, and even if there is exclusiveness in the shapes of the R, G, B LED chips, the applied DEP forces are similar or the difference is not large, so there is a screen effect problem in which other LED chips block the entrance of the assembly hole.

On the other hand, when applying the first assembly substrate structure (300A1) for a display pixel and the first semiconductor light-emitting device package (350A) according to the embodiment, an inclination angle (Θ) of a semiconductor light-emitting device at a misassembled position can be controlled to about 10° or more, and accordingly, in the case of the embodiment, the light-emitting device chip at the misassembled position is removed by itself by magnetic force so that a correct assembly probability can be increased, and there is a technical effect capable of solving a screen effect problem in which an LED chip blocks an entrance of an assembly hole.

For example, when a circular first semiconductor light-emitting device (350R) or an elliptical third semiconductor light-emitting device (350B) is located in a heterotypical second assembly hole (301b), inclination angles (Θ) were studied to be about 17.8° and about 17.1°, respectively, which are about 17° or more.

Also, when the circular first semiconductor light-emitting device (350R) or a heterotypical second semiconductor light-emitting device (350G) is located in an elliptical third assembly hole (301c), inclination angles (Θ) were studied to be about 12.9° and about 13.34°, respectively, which are about 12° or more.

Accordingly, since the DEP force applied to each of the light-emitting device chips at the misassembled position is at a very weak level, the DEP force applied to the corresponding chips at the misassembled position becomes smaller than the magnetic force applied by a magnet, so that the light-emitting device chips at the misassembled position are removed by themselves by the magnetic force to increase the correct assembly probability, and there is a special technical effect capable of solving the screen effect problem in which the LED chip at the misassembled position blocks the entrance of the assembly hole.

② Also, when applying the first semiconductor light-emitting device package (350A) according to the embodiment, a problem of an LED chip being broken in an LLO process can be solved by controlling a long-to-short axis ratio between chips to an appropriate level, for example, 2.5 or less.

For example, in the case of a 25 µm circular chip, a long-to-short axis ratio (a3/b3) of the elliptical third semiconductor light-emitting device (350B) is about 2.17, and in the case of a 21 µm circular chip, the long-to-short axis ratio (a3/b3) of the elliptical third semiconductor light-emitting device (350B) is about 2.5. As the long-to-short axis ratio is controlled to about 2.5 or less like this, there is a technical effect that the elliptical third semiconductor light-emitting device (350B) is not broken in the LLO process or the like.

③ Also, as the long-to-short axis ratio is controlled to about 2.5 or less, there is an effect of increasing an assembling probability of being assembled in an assembly hole. According to the embodiment, even in a case where exclusiveness is increased by providing more difference in horizontal cross-sectional shapes in respective assembly holes among R, G, and B LED chips, there is an effect of increasing an assembling probability that the second and third semiconductor light-emitting devices are assembled in the respective second assembly hole and third assembly hole as the long-to-short axis ratio is controlled to about 2.5 or less.

④ Also, according to the embodiment, as areas of the heterotypical second semiconductor light-emitting device (350G) and the elliptical third semiconductor light-emitting device (350B) increase, an area of an active layer, which is a light-emitting region, increases, so that there is an effect of improving luminance.

### <Second Embodiment>

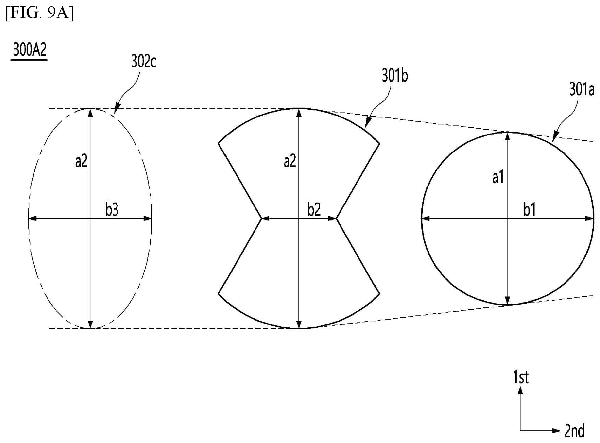

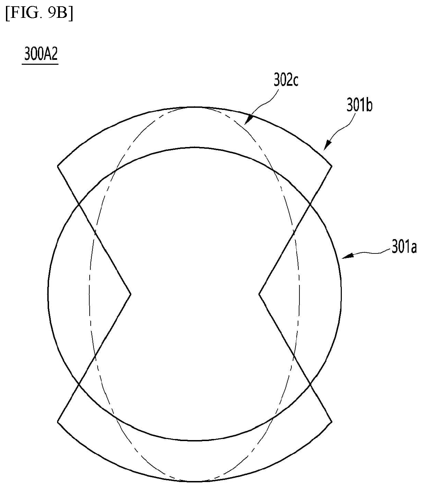

Next, FIG. 9A is a plan view of a second assembly substrate structure (300A2) for a display pixel according to an embodiment, and FIG. 9B is an exemplary view showing each assembly hole shown in FIG. 9A in an overlapping manner.

Referring to FIG. 9A, a second assembly substrate structure (300A2) according to an embodiment may include a first assembly hole (301a), a second assembly hole (301b), and a 3-2 assembly hole (302c) in consideration of a shape of a light-emitting device to be assembled.

A horizontal cross-section of the first assembly hole (301a) may be circular, and a horizontal cross-section of the 3-2 assembly hole (302c) may be elliptical. At this time, a horizontal cross-section of the second assembly hole (301b) may be heterotypical.

For example, upper and lower sides of the horizontal cross-section of the second assembly hole (301b) may include a predetermined arc with half of a long axis length. For example, the horizontal cross-section of the second assembly hole (301b) may have a symmetrical shape with a narrow middle. For example, the horizontal cross-section of the second assembly hole (301b) may have a dumbbell shape with a narrow middle, but is not limited thereto.

Unlike the first assembly substrate structure (300A1), in the second assembly substrate structure (300A2), an elliptical 3-2 assembly hole (301c2) may have the same height (same long axis) as the heterotypical second assembly hole (301b), but is not limited thereto.

According to an embodiment, a second semiconductor light-emitting device package (not shown) assembled on the second assembly substrate structure (300A2) for a display pixel may be included.

For example, the second semiconductor light-emitting device package may include a first semiconductor light-emitting device (not shown), a second semiconductor light-emitting device (not shown), and a 3-2 semiconductor light-emitting device (not shown) assembled in the first assembly hole (301a), the second assembly hole (301b), and the 3-2 assembly hole (302c), respectively.

Shapes of the first semiconductor light-emitting device, the second semiconductor light-emitting device, and the 3-2 semiconductor light-emitting device may correspond to shapes of the first assembly hole (301a), the second assembly hole (301b), and the 3-2 assembly hole (302c), respectively.

Hereinafter, the description will focus on the second assembly substrate structure (300A2) for a display pixel, and these features may also be applied to the second semiconductor light-emitting device package assembled on the second assembly substrate structure (300A2) for a display pixel.

Continuing to refer to FIG. 9A, the first assembly hole (301a) may include a first-direction first width (a1) and a second-direction first width (b1).

Next, the second assembly hole (301b) may include a first-direction second width (a2) and a second-direction second width (b2), and the 3-2 assembly hole (302c) may include a first-direction second width (a2) and a second-direction third width (b3).

In the second assembly substrate structure (300A2) for a display pixel, increments in long-axis direction lengths of the second assembly hole (301b) and the 3-2 assembly hole (302c) based on the circular first assembly hole (301a) may be the same as each other.

For example, when the first assembly hole (301a) has a circular cross-section in which a first-direction first width (a1) and a second-direction first width (b1) are each 25 µm and an exclusive interval is 7 µm, a first-direction second width (a2) of the second assembly hole (301b) may be 32 µm, and a first-direction second width (a2) of the 3-2 assembly hole (302c) may also be 32 µm, but they are not limited thereto.

On the other hand, in the second assembly substrate structure (300A2) for a display pixel, a decrement in a short-axis length of the second assembly hole (301b) and the 3-2 assembly hole (302c) based on the circular first assembly hole (301a) may be crossed and decreased. For example, the decrement in the short-axis direction of the second assembly hole (301b) may be greater than the decrement in the short-axis direction of the 3-2 assembly hole (302c). Accordingly, the second width (b2) in the short-axis direction of the second assembly hole (301b) may be smaller than the third width (b3) in the short-axis direction of the 3-2 assembly hole (302c).

For example, when the first assembly hole (301a) has a circular cross-section in which a first-direction first width (a1) and a second-direction first width (b1) are each 25 µm and an exclusive interval is 7 µm, a second-direction third width (b3) of the 3-2 assembly hole (302c) may be 18 µm, and a second-direction second width (b2) of the second assembly hole (301b) may be 11 µm.

Hereinafter, technical effects according to the second assembly substrate structure (300A2) for a display pixel according to an embodiment will be described in detail. Also, these technical effects may be applied to the second semiconductor light-emitting device package according to an embodiment.

① First, unlike the internal technology, even if the sizes of the LED chips become smaller than 30 µm, an area difference between the circular first semiconductor light-emitting device, which is a reference chip, and the remaining second semiconductor light-emitting device and 3-2 semiconductor light-emitting device having different shapes can be controlled such that a DEP force is at a uniform level.

For example, when the size of the circular first semiconductor light-emitting device is 25 µm and an exclusive interval is set to 7 µm, it was studied that areas of the heterotypical second semiconductor light-emitting device and the elliptical 3-2 semiconductor light-emitting device are about 110.45% and about 92.16% relative to the area of the circular first semiconductor light-emitting device, respectively, so that an area difference of about 10% occurs.

Also, even when the size of the circular first semiconductor light-emitting device is 21 µm and the exclusive interval is set to 7 µm, it was studied that areas of the heterotypical second semiconductor light-emitting device and the elliptical 3-2 semiconductor light-emitting device are at levels of about 104.8% and about 88.9% relative to the area of the circular first semiconductor light-emitting device, respectively, and an area difference of about 10% occurs.

Accordingly, according to the second assembly substrate structure (300A2) for a display pixel and the second semiconductor light-emitting device package according to the embodiment, there is a technical effect of increasing an assembly rate as the DEP Force acting on each of the chips is uniformly controlled in simultaneous assembly of RGB chips.

Also, as can be seen in FIG. 6 above, when an inclination angle (Θ) range of the LED chip in the assembly hole exceeds about 10° or more, a DEP force significantly decreases and there is a DEP force selectivity.

When applying the second assembly substrate structure (300A2) for a display pixel and the second semiconductor light-emitting device package according to the embodiment, an inclination angle (Θ) of a semiconductor light-emitting device at a misassembled position can be controlled to about 10° or more. Accordingly, in the case of the embodiment, the light-emitting device chip at the misassembled position is removed by itself by magnetic force so that a correct assembly probability can be increased, and there is a technical effect capable of solving a screen effect problem in which an LED chip blocks an entrance of an assembly hole.

② Also, when applying the second semiconductor light-emitting device package according to the embodiment, a problem of an LED chip being broken in an LLO process can be solved by controlling a long-to-short axis ratio between chips to an appropriate level, for example, 2.5 or less.

For example, in the case of a 25 µm circular chip, a long-to-short axis ratio of the elliptical 3-2 semiconductor light-emitting device is about 1.78, and in the case of a 21 µm circular chip, the long-to-short axis ratio of the elliptical 3-2 semiconductor light-emitting device is about 2.0. As the long-to-short axis ratio is controlled to about 2.0 or less like this, there is a technical effect of high reliability without the elliptical 3-2 semiconductor light-emitting device being broken in the LLO process or the like.

③ Also, as the long-to-short axis ratio is controlled to about 2.0 or less, there is an effect of increasing an assembling probability of being assembled in an assembly hole. According to the embodiment, even in a case where exclusiveness is increased by providing more difference in horizontal cross-sectional shapes in respective assembly holes among R, G, and B LED chips, there is an effect of increasing an assembling probability that the second and 3-2 semiconductor light-emitting devices are assembled in the respective second assembly hole and 3-2 assembly hole as the long-to-short axis ratio is controlled to about 2.0 or less.

④ Also, according to the embodiment, as areas of the heterotypical second semiconductor light-emitting device and the elliptical 3-2 semiconductor light-emitting device increase, an area of an active layer, which is a light-emitting region, increases, so that there is an effect of improving luminance.

According to the embodiment, while having a micro-LED size that can be adopted for HD TVs, VR, AR, XR, and the like, exclusiveness among R, G, and B LED chips is secured, so that there is a technical effect of increasing an assembling probability of R, G, and BLED chips capable of self-emitting R, G, and B colors.

Also, according to the embodiment, in a self-assembly method using dielectrophoresis (DEP), there is a technical effect capable of increasing an assembling probability while making a DEP force uniform for LED chips of each color.

For example, ① unlike the internal technology, even if sizes of LED chips are reduced to 30 µm or less, an area difference between the circular first semiconductor light-emitting device (350R), which is a reference chip, and the remaining second semiconductor light-emitting device (350G) and third semiconductor light-emitting device (350B) having different shapes can be controlled to an area difference of about 10%.

Accordingly, according to the assembly substrate structure for a display pixel and the semiconductor light-emitting device package according to the embodiment, in simultaneous assembly of RGB chips, a DEP Force acting on each chip is uniformly controlled, so that there is a technical effect of increasing an assembly rate.

Also, when applying the assembly substrate structure for a display pixel and the first semiconductor light-emitting device package according to the embodiment, an inclination angle (Θ) of a semiconductor light-emitting device at a misassembled position can be controlled to about 10° or more. Accordingly, in the case of the embodiment, the light-emitting device chip at the misassembled position is removed by itself by magnetic force so that a correct assembly probability can be increased, and there is a technical effect capable of solving a screen effect problem in which an LED chip blocks an entrance of an assembly hole.

② Also, when applying the semiconductor light-emitting device package according to the embodiment, a problem of an LED chip being broken in an LLO process can be solved by controlling a long-to-short axis ratio between chips to an appropriate level, for example, 2.5 or less or 2.0 or less.

③ Also, as the long-to-short axis ratio is controlled to about 2.5 or less, there is an effect of increasing an assembling probability of being assembled in an assembly hole. According to the embodiment, even in a case where exclusiveness is increased by providing more difference in horizontal cross-sectional shapes in respective assembly holes among R, G, and B LED chips, there is an effect of increasing an assembling probability that the second and third semiconductor light-emitting devices are assembled in the respective second assembly hole and third assembly hole as the long-to-short axis ratio is controlled to about 2.5 or less.

④ Also, according to the embodiment, as areas of the heterotypical second semiconductor light-emitting device (350G) and the elliptical third semiconductor light-emitting device (350B) increase, an area of an active layer, which is a light-emitting region, increases, so that there is an effect of improving luminance.

The above detailed description should not be interpreted as restrictive in all aspects and should be considered as exemplary. The scope of the embodiment should be determined by a reasonable interpretation of the appended claims, and all changes within the equivalent scope of the embodiment are included in the scope of the embodiment.

### [Industrial Applicability]

An embodiment can be adopted in a display field for displaying an image or information.

An embodiment can be adopted in a display field for displaying an image or information using a semiconductor light-emitting device.

An embodiment can be adopted in a display field for displaying an image or information using a micro-scale or nano-scale semiconductor light-emitting device.

## Claims

1. An assembly substrate structure for a display pixel, comprising:
a first assembly hole having a circular shape and disposed in a first region of a predetermined assembly substrate;
a second assembly hole disposed in a second region of the assembly substrate; and
a third assembly hole having an elliptical shape and disposed in a third region of the assembly substrate,
wherein each of the first assembly hole, the second assembly hole, and the third assembly hole has a width in a first direction and a width in a second direction perpendicular to the first direction,
wherein an increment of the width in the first direction of the second assembly hole and the third assembly hole increases at a predetermined exclusive interval based on the width in the first direction of the first assembly hole, and
wherein a decrement of the width in the second direction of the second assembly hole and the third assembly hole is such that the decrements intersect based on the width in the second direction of the first assembly hole.

2. The assembly substrate structure for a display pixel of claim 1, wherein the decrement of the width in the second direction of the second assembly hole is greater than the decrement of the width in the second direction of the third assembly hole.

3. The assembly substrate structure for a display pixel of claim 2, wherein the width in the second direction of the second assembly hole is smaller than the width in the second direction of the third assembly hole.

4. The assembly substrate structure for a display pixel of claim 1, wherein the second assembly hole includes an arc at an upper side and a lower side among a horizontal cross-section.

5. The assembly substrate structure for a display pixel of claim 4, wherein an upper side and a lower side among the horizontal cross-section of the second assembly hole include a predetermined arc based on half of a length of the width in the first direction.

6. The assembly substrate structure for a display pixel of claim 1, wherein a horizontal cross-section of the second assembly hole includes a symmetrical shape with a constricted middle.

7. The assembly substrate structure for a display pixel of claim 1, wherein a horizontal cross-section of the second assembly hole (301b) includes a dumbbell shape with a constricted middle.

8. A semiconductor light-emitting device package for a display pixel comprising:
a circular first semiconductor light-emitting device disposed in a first region of a predetermined assembly substrate;
a second semiconductor light-emitting device disposed in a second region of the assembly substrate; and
an elliptical third semiconductor light-emitting device disposed in a third region of the assembly substrate;
wherein the first semiconductor light-emitting device, the second semiconductor light-emitting device, and the third semiconductor light-emitting device each include a width in a first direction and a width in a second direction perpendicular to the first direction,
wherein an increment of the width in the first direction of the second semiconductor light-emitting device and the third semiconductor light-emitting device increases at a predetermined exclusive interval based on the width in the first direction of the first semiconductor light-emitting device, and
wherein a decrement of the width in the second direction of the second semiconductor light-emitting device and the third semiconductor light-emitting device is such that the decrements intersect based on the width in the second direction of the first semiconductor light-emitting device.

9. The semiconductor light-emitting device package for a display pixel of claim 8, wherein the decrement of the width in the second direction of the second semiconductor light-emitting device is greater than the decrement of the width in the second direction of the third semiconductor light-emitting device.

10. The semiconductor light-emitting device package for a display pixel of claim 9, wherein the width in the second direction of the second semiconductor light-emitting device is smaller than the width in the second direction of the third semiconductor light-emitting device.

11. The semiconductor light-emitting device package for a display pixel of claim 8, wherein the second semiconductor light-emitting device includes an arc at an upper side and a lower side among a horizontal cross-section.

12. The semiconductor light-emitting device package for a display pixel of claim 11, wherein an upper side and a lower side among the horizontal cross-section of the second semiconductor light-emitting device include a predetermined arc based on half of a length of the width in the first direction.

13. The semiconductor light-emitting device package for a display pixel of claim 8, wherein a horizontal cross-section of the second semiconductor light-emitting device includes a symmetrical shape with a constricted middle.

14. The semiconductor light-emitting device package for a display pixel of claim 8, wherein a horizontal cross-section of the second semiconductor light-emitting device (301b) includes a dumbbell shape with a constricted middle.

15. A display apparatus comprising a semiconductor light-emitting device, comprising the assembly substrate structure for a display pixel of claims 1 to 7.

16. A display apparatus comprising a semiconductor light-emitting device, comprising the semiconductor light-emitting device package for a display pixel of claims 8 to 14.
